# EUROPÄISCHE PATENTSCHRIFT

(11) **EP 2 812 916 B1**
(45) Veröffentlichungstag und Bekanntmachung des Hinweises auf die Patenterteilung: **18.12.2019**
(21) Anmeldenummer: 13709539.4
(22) Anmeldetag: 17.01.2013
(51) Int. Cl.: H01L 21/67, H01L 21/677

(54) **PROZESSMODUL**
TREATMENT MODULE
MODULE DE TRAITEMENT

(30) Priorität: 06.02.2012 DE 102012100927
(43) Veröffentlichungstag der Anmeldung: 17.12.2014
(73) Patentinhaber: Meyer Burger (Germany) GmbH, 09337 Hohenstein-Ernstthal (DE)
(72) Erfinder: MAI, Joachim, 04603 Nobitz (DE); MUELLER, Danny, 09123 Chemnitz (DE); RASCHKE, Sebastian, 09380 Thalheim (DE); HEINZE, Andreas, 98708 Gehren (DE)
(74) Vertreter: Steiniger, Carmen
(86) Internationale Anmeldenummer: PCT/IB2013/050416
(87) Internationale Veröffentlichungsnummer: WO 2013/118004

(56) Entgegenhaltungen:
- EP-A1- 1 953 259
- EP-A2- 0 829 904
- EP-A2- 1 749 901
- WO-A1-2009/156196
- WO-A1-2011/018226
- DE-A1- 4 324 320
- US-A1- 2003 034 228
- US-A1- 2005 145 335
- US-A1- 2008 251 376
- US-A1- 2010 065 696

## Beschreibung

Die vorliegende Erfindung betrifft ein Prozessmodul mit wenigstens einer in dem Prozessmodul befindlichen evakuierbaren Prozesskammer und wenigstens einer horizontal durch das Prozessmodul in wenigstens einer Substrattransportrichtung bewegbaren Trägervorrichtung zur Aufnahme von jeweils wenigstens einem flächigen, in der Prozesskammer zu prozessierenden Substrat.

Bei der Massenproduktion von flächigen Produkten, wie beispielsweise Solarzellen, haben sich großformatige Durchlaufanlagen bewährt. Beispiele für solche Durchlaufanlagen sind Durchlaufrollenöfen zur thermischen Behandlung von Substraten und Durchlaufbeschichtungsanlagen, wie sie beispielsweise aus der Druckschrift WO 2011/080659 A1 bekannt sind. In einer solchen Anlage werden mehrere Substrate, beispielsweise quadratische Solarzellenwafer, auf einer Trägervorrichtung abgelegt und durchlaufen dann eine modular aufgebaute Anlage mit mehreren Prozessmodulen, in welchen jeweils eine Substratbearbeitung erfolgt. Problematisch bei kostengünstig aufgebauten Durchlaufanlagen ist die Befriedigung ständig wachsender Anforderungen an die hergestellten Produkte. Hierzu gehören zum Beispiel erhöhte Anforderungen an die Gasreinheit während Plasmabehandlungen von Substraten.

Eine hohe Reinheit von Plasmabearbeitungsanlagen kann beispielsweise in Ultrahochvakuum- und Hochvakuumanlagen realisiert werden. Die Verwendung solcher hochpreisiger Anlagen scheidet jedoch aus Kostengründen bei der Herstellung von Niedrigpreisprodukten aus. Aus der Druckschrift WO 2011/095846 A1 sind auch Parallelplattenreaktoren bekannt, bei denen hohe Anforderungen an eine plasmagestützte CVD-Abscheidung erfüllt werden und welche dennoch mit relativ geringen Anlagenkosten verbunden sind. Es besteht jedoch immer der Wunsch, die Qualität von Produkten zu erhöhen und die Produktionskosten zu senken.

Es ist daher die Aufgabe der vorliegenden Erfindung, ein Prozessmodul der oben genannten Gattung vorzuschlagen, das bei großer Produktionsgeschwindigkeit eine gleichmäßige und hochwertige Bearbeitung aller Substrate bei möglichst niedrigen Anlagenkosten ermöglicht.

Diese Aufgabe wird durch ein Prozessmodul der eingangs genannten Gattung gelöst, bei dem die wenigstens eine Prozesskammer durch die Trägervorrichtung, deren Position in wenigstens einer Schließrichtung quer zu der Substrattransportrichtung veränderbar ist, gegenüber dem Prozessmodul körperlich abschließbar ist, wobei die wenigstens eine Trägervorrichtung einen Boden der wenigstens einen Prozesskammer ausbildet. Eine solche Anlage ist etwa aus der Druckschrift US 2008/0251376 bekannt.

Dieses Prozessmodul ist nach dem Kammer-in-Kammer-Prinzip aufgebaut. Dabei stellt das Prozessmodul eine äußere Kammer dar, in welche die Prozesskammer als innere Kammer eingebaut ist. Die Prozesskammer kann dabei entweder am Kammerdeckel des Prozessmoduls befestigt werden und/oder wird mit Hilfe spezieller Trageelemente vom Boden getragen. In einigen Fällen kann die Prozesskammer auch an einer Zwischendecke bzw. einem Zwischenboden und/oder an Seitenwänden des Prozessmoduls befestigt werden. Die Art und Weise der Befestigungsvariante wird dabei vorwiegend durch die technischen und technologischen Erfordernisse der Prozesskammer und/oder der Prozessmoduls beeinflusst und definiert.

Durch diesen Aufbau wird eine bessere Trennung des Prozessbereiches von der äußeren Atmosphäre bzw. von Hilfsvorrichtungen, die z.B. für den Substrattransport innerhalb des Prozessmoduls benötigt werden, als bei einer einzelnen Kammer erreicht. Auf diese Weise kann auch die Konzentration von Verunreinigungsgasen in der Prozesskammer reduziert und die Genauigkeit der Temperatureinstellungen der Prozesskammer verbessert werden. Da Plasmabearbeitungsprozesse, wie beispielsweise eine plasmagestützte chemische Gasphasenabscheidung, temperaturabhängig sind, bewirkt eine erhöhte Genauigkeit der Temperatureinstellung auch eine erhöhte Qualität bei der Homogenität der Substratbearbeitung. Ein weiterer Vorteil besteht darin, dass der unmittelbare Prozessbereich für die Substratbearbeitung so abgegrenzt werden kann, dass die vorwiegend vom Gasaustausch abhängigen Einschwingvorgänge, beim Einschalten des Plasmas, definierter und kürzer ablaufen können.

In dem erfindungsgemäßen Prozessmodul ist die Prozesskammer besonders einfach und entsprechend kostengünstig dadurch realisiert, dass die Trägervorrichtung den Boden der Prozesskammer ausbildet. Die ohnehin vorhandene Trägervorrichtung bildet dabei gleichzeitig den Boden und den Verschluss der Prozesskammer aus. Dabei ist nur die Seite der Trägervorrichtung, auf welcher das wenigstens eine Substrat vorgesehen ist, in der Prozesskammer. Die weiteren Elemente der Trägervorrichtung befinden sich außerhalb der Prozesskammer. Dadurch kann das Innenvolumen der Prozesskammer minimiert werden, wodurch Abpump-, Spül- und Belüftungszeiten reduziert und in der Folge Kosten gespart werden können.

In dem Prozessmodul können dabei auch mehrere Prozesskammern angeordnet sein. Beispielsweise können, wie nachfolgend näher erläutert, zwei Prozesskammern vorhanden sein, deren Böden durch zwei Trägervorrichtungen ausgebildet werden.

Die Trägervorrichtung ist erfindungsgemäß innerhalb des Prozessmoduls horizontal bewegbar. Das Prozessmodul kann dabei beispielsweise als Modul einer Durchlaufanlage ausgebildet sein. In diesem Fall gibt es nur eine Substrattransportrichtung, die Durchlaufrichtung durch die Durchlaufanlage. Das Prozessmodul kann in einer anderen Ausbildung aber auch ein Endmodul sein, das nur eine Öffnung zum An- und Abtransportieren von wenigstens einer Trägervorrichtung aufweist. In diesem Fall gibt es zwei Substrattransportrichtungen, eine Einbringrichtung und eine hierzu entgegengesetzte Entnahmerichtung.

Je nach verwendetem Transportsystem kann die Substrattransportrichtung eine eindimensionale Bewegungsrichtung oder auch eine gekrümmte Bewegungsrichtung sein. Die Bewegung der Trägervorrichtung in der Substrattransportrichtung führt noch nicht zum Abschließen der Prozesskammer. Zum Abschließen der Prozesskammer wird die Trägervorrichtung in der Schließrichtung in Richtung der unbeweglichen Teile der Prozesskammer bewegt. Die Schließrichtung ist in der Regel eine nach oben gerichtete vertikale Bewegung, sie kann aber auch eine Bewegung in einem Winkel zur Vertikalen sein. In jedem Fall ist die Schließrichtung nicht identisch mit der Substrattransportrichtung, sondern die Schließrichtung ist quer, also in einem großen Winkel, zu der Substrattransportrichtung ausgerichtet. Durch die Bewegung der Trägervorrichtung in die Schließrichtung kann die Prozesskammer geschlossen werden. Durch die Bewegung der Trägervorrichtung entgegen der Schließrichtung kann die Prozesskammer entsprechend wieder geöffnet bzw. der Abstand zwischen der Trägervorrichtung und der Prozesskammer vergrößert werden. Die Prozessierung in der Prozesskammer erfolgt dabei in der Regel bei geschlossener Prozesskammer, es können jedoch auch Prozessierungen bei geöffneter Prozesskammer vorgesehen sein.

In einer bevorzugten Ausbildung des erfindungsgemäßen Prozessmoduls ist die wenigstens eine Trägervorrichtung elektrisch leitfähig oder besitzt wenigstens eine elektrisch leitfähige Oberfläche. Die Trägervorrichtung kann dadurch eine Elektrode ausbilden, die elektrisch mit dem Plasma gekoppelt ist und eine Bewegung von Ladungsträgern aus dem Plasma in Richtung der Trägervorrichtung bewirkt. Zur Ausbildung eines Stromkreises, der das Plasma und die Trägervorrichtung enthält, muss die Trägervorrichtung elektrisch leitfähig sein.

Die Oberfläche der Trägervorrichtung muss im Inneren der Prozesskammer zudem aus einem prozesskompatiblen Material bestehen. Das heißt, die Trägervorrichtung darf durch die in der Prozesskammer ausgeführten Prozesse nicht beschädigt werden, und von der Trägervorrichtung dürfen keine Verunreinigungen in die Prozesskammer abgegeben werden. Wenn beispielsweise in der Prozesskammer wechselweise eine CVD-Abscheidung von Siliziumnitrid und eine Kammerreinigung mit einem chlor- und/oder fluorhaltigen Reinigungsgas durchgeführt werden, kommt als prozesskompatibles Material Aluminium in Frage. Zwischen Aluminium und Siliziumnitrid besteht eine gute Haftung, sodass keine vorzeitige Partikelbildung durch Abplatzungen zu befürchten ist. Des Weiteren ist Aluminium in verschiedensten Ätzgasen beständig, sodass in den Reinigungsprozessen keine undefinierte Korrosion an der Trägervorrichtung auftritt. Bei anderen Prozessen sind andere Materialeigenschaften zum Erreichen der Prozesskompatibilität nötig. Beispielsweise kann für einen Sauerstoffplasmabehandlungsprozess eine Oxidierbarkeit oder für einen Hochtemperaturbehandlungsprozess eine hohe Temperaturbeständigkeit gefordert sein.

Entsprechend einer vorteilhaften Ausgestaltung des erfindungsgemäßen Prozessmoduls sind Anschlüsse der Prozesskammer für gasförmige, flüssige und/oder elektrische Medien in einer Decke und/oder in wenigstens einer Seitenwand der Prozesskammer angeordnet. Für die Prozessierung in der Prozesskammer wird in der Regel eine definierte Atmosphäre benötigt. Zur Herstellung dieser definierten Atmosphäre müssen bestimmte Gase zugeführt werden. Andere Gase, beispielsweise die Reaktionsprodukte einer chemischen Gasphasenreaktion, müssen aus der Prozesskammer abgepumpt werden. Außerdem sind mitunter flüssige Medien, beispielsweise Kühlwasser, in die Prozesskammer einzuführen. Für die Erzeugung eines Plasmas muss zudem elektrische Energie in die Prozesskammer eingeführt werden. Die verschiedenen Anschlüsse für die einzelnen Medien werden vorzugsweise in den unbewegten Teilen der Prozesskammer, also in der Decke oder in wenigstens einer Seitenwand der Prozesskammer, realisiert. Unbewegte Anschlüsse sind in der Regel einfacher und zuverlässiger als bewegte Anschlüsse. Die Anschlüsse können in einer Wand der Prozesskammer oder verteilt auf mehrere Wände angeordnet sein.

Die Prozessierung der Substrate ist hauptsächlich in der Prozesskammer vorgesehen. Daher kann lediglich die evakuierbare Prozesskammer mit einem Pumpanschluss versehen sein. Der Außenraum um die Prozesskammer herum wird in dem Prozessmodul in diesem Fall entweder über den Pumpanschluss der Prozesskammer oder über den Pumpanschluss eines Nachbarmoduls des Prozessmoduls gespült. In einer günstigeren Weiterbildung des Prozessmoduls weist dieses jedoch einen eigenen Pumpanschluss auf, sodass aus dem Prozessmodul unabhängig von der Prozesskammer Gase, beispielsweise zur Reduzierung von Verunreinigungen, abgepumpt werden können. Darüber hinaus ist es vorteilhaft, wenn auch das Prozessmodul einen eigenen Gaseinlass besitzt.

In einem vorteilhaften Beispiel des erfindungsgemäßen Prozessmoduls weist das Prozessmodul wenigstens ein Temperierelement zur Temperierung der Decke und/oder wenigstens einer Seitenwand der Prozesskammer auf, wobei das Temperierelement eine Heizvorrichtung und/oder eine Kühlvorrichtung ist. Die Temperaturen können während der Prozessierung besonders zuverlässig eingestellt werden, wenn nicht nur die Substrate, sondern die gesamte Prozesskammer temperiert werden. Je nach verwendeten Prozesstemperaturen können verschiedene Temperierelemente zum Einsatz kommen. Bei hohen benötigten Temperaturen ist das Temperierelement regelmäßig als Heizvorrichtung ausgebildet. Die Heizvorrichtung kann beispielsweise eine Widerstands- oder eine Lampenheizung sein. Beispielsweise kann es bei niedrigen Prozesstemperaturen aber auch erforderlich sein, dass die Prozesskammer gekühlt wird oder dass die Temperatur zwischen Kühlung und Heizung geregelt wird. Für solche Aufgaben können Temperierelemente zum Einsatz kommen, die aus einer Kombination von Kühlvorrichtung und Heizvorrichtung bestehen oder die eine regelbare Temperatur aufweisen. Eine Temperaturregelung ist beispielsweise über eine temperaturgeregelte Flüssigkeit möglich.

In einer weiteren Ausführungsform des erfindungsgemäßen Prozessmoduls besitzt die wenigstens eine Prozesskammer wenigstens einen HF-tauglichen Anschluss oder Kontakt für die Trägervorrichtung. Wenn die Trägervorrichtung als Elektrode für ein HF-Plasma verwendet wird, muss die Trägervorrichtung in einen HF-Stromkreis eingebunden werden. An elektrische Leiter für HF-Ströme bestehen andere Anforderungen als an Leiter für Gleichströme. Für die elektrische Verbindung der Trägervorrichtung ist deshalb ein Anschluss oder ein Kontakt für die Trägervorrichtung vorgesehen. Bei einem Kontakt wird die elektrische Verbindung lediglich durch Andrücken der Trägervorrichtung hergestellt, bei einem Anschluss wird hingegen mit Hilfe einer Mechanik die elektrische Verbindung hergestellt. Dieser Anschluss oder Kontakt ist vorzugsweise eine Komponente der Prozesskammer. In alternativen Ausbildungen kann der Anschluss oder Kontakt aber auch zumindest teilweise Teil der Trägervorrichtung und/oder des Prozessmoduls sein.

Der HF-taugliche Anschluss oder Kontakt ist in der Regel ein Masseanschluss. Das heißt, über den Anschluss oder Kontakt wird die Trägervorrichtung mit Masse verbunden, sodass der HF-Strom in Richtung Masse fließen kann. Alternativ kann der Anschluss oder Kontakt jedoch auch von der Masse isoliert sein, sodass an die Trägervorrichtung ein anderes Potenzial als Massepotenzial oder eine Wechselspannung angelegt werden kann. Mit dem Anlegen einer Wechselspannung können verschiedene Ziele verfolgt werden. In einem Beispiel kann eine HF-Leistung eingekoppelt werden, um in der Prozesskammer ein Plasma zu erzeugen. In einem anderen Ausführungsbeispiel kann die Trägervorrichtung mit einem Potenzial beaufschlagt werden, um Ionen aus einem anderweitig erzeugten Plasma zu extrahieren. Das Beaufschlagen der Trägervorrichtung mit einem anderen Potenzial als dem Massepotenzial ist jedoch sehr aufwändig, da konstruktiv durch geeignete Isolatoren eine Plasmazündung außerhalb der Prozesskammer und an Randbereichen in der Prozesskammer vermieden werden muss. Der HF-Kontakt kann sowohl als körperlicher, mechanischer Kontakt als auch als kapazitiver Kontakt ausgebildet sein. Ein kapazitiver Kontakt kann beispielsweise durch eine parallel zur Trägervorrichtung angeordnete Elektrodenplatte ausgebildet werden.

Gemäß der erfindungsgemäßen, konstruktiven Gestaltung weist das erfindungsgemäße Prozessmodul ein Transportsystem zum Hintransportieren der Trägervorrichtung zu der Prozesskammer und/oder zum Wegtransportieren der Trägervorrichtung von der Prozesskammer auf, wobei das Hin- und/oder Wegtransportieren in einer Transportebene parallel zu einer horizontalen Ausdehnung der Prozesskammer vorgesehen ist. Das erfindungsgemäße Prozessmodul kann unter anderem für die Bearbeitung mechanisch großer Trägervorrichtungen eingestellt werden. Zum Bewegen großer und schwerer Substrate und Trägervorrichtungen sind Transportvorrichtungen, wie beispielsweise Roboterarme, die bei kleinen und leichten Substraten zum Einsatz kommen, schlecht geeignet. Zum Transportieren der Trägervorrichtung sind hingegen Transportsysteme vorteilhaft, die auch innerhalb des Prozessmoduls eine Abstützung der Trägervorrichtung gewährleisten. Das verwendete Transportsystem realisiert dabei eine horizontale Bewegung der Trägervorrichtung, die mit Substraten beladen ist, bis zu der Prozesskammer hin und nach der Bearbeitung von der Prozesskammer weg. In einer Durchlaufanlage ist die Bewegungsrichtung der Trägervorrichtung die Durchlaufrichtung, in anderen Anlagen kann die Wegtransportrichtung zu der Hintransportrichtung entgegengesetzt sein.

In besonders geeigneten Ausbildungen des erfindungsgemäßen Prozessmoduls weist das Transportsystem Transportrollen und/oder einen Linearmotorantrieb auf. Mit Transportrollen und Linearmotorantrieben wird eine regelmäßige oder kontinuierliche Abstützung der Trägervorrichtung erreicht, sodass kein Durchhängen oder Durchbiegen der Trägervorrichtung auftritt. Dadurch kann das Prozessmodul kompakt ausgebildet werden und es muss kein Raum für durchhängende Transportvorrichtungen zur Verfügung gestellt werden. Das Transportsystem muss jedoch nicht zwingend Transportrollen oder einen Linearmotorantrieb aufweisen, es sind auch andere Ausbildungen von Transportsystemen möglich, beispielsweise ein abgestützter Transportarm.

Es ist besonders von Vorteil, wenn sich alle Antriebskomponenten des Transportsystems des erfindungsgemäßen Prozessmoduls außerhalb der Prozesskammer befinden. Bei dieser Ausbildung kann die Prozesskammer besonders flach ausgebildet werden und die Antriebskomponenten des Transportsystems werden keiner Belastung durch den Prozess in der Prozesskammer ausgesetzt.

In einer bevorzugten Ausbildung des erfindungsgemäßen Prozessmoduls weist das Prozessmodul ein Hubsystem zum Anheben der Trägervorrichtung in eine Prozessierungsebene und zum Absenken der Trägervorrichtung in eine Transportebene auf, wobei die Trägervorrichtung in der Prozessierungsebene als Boden der Prozesskammer vorgesehen ist. In dieser Ausbildung ist die Transportmechanik für die Trägervorrichtung von der Schließmechanik für die Prozesskammer getrennt. In der Transportebene ist ein einfacher Transport der Trägervorrichtung möglich, wobei wegen hinreichend großer Abstände keine mechanische Justage zwischen Prozessmodul und Trägervorrichtung erforderlich ist. Das Schließen der Prozesskammer wird mit Hilfe des Hubsystems realisiert, das die Trägervorrichtung gegen die unbewegten Teile der Prozesskammer drückt, sodass die Trägervorrichtung den Boden der geschlossenen Prozesskammer ausbildet. Das Hubsystem führt eine im Wesentlichen senkrechte Hubbewegung aus, bei der die Trägervorrichtung gegen Dichtflächen gedrückt wird. Auf diese Weise wird eine gute Abdichtung der Prozesskammer erreicht. Primär ist der Betrieb der Prozesskammer im geschlossenen Zustand vorgesehen, wobei sich die Trägervorrichtung in der Prozessierungsebene befindet. Das Hubsystem gestattet jedoch auch das Absenken der Trägervorrichtung in Ebenen, die unter der Prozessierungsebene liegen. In diesen Ebenen können ebenfalls Prozessierungen, beispielsweise Reinigungsprozesse, vorgesehen sein. Alternativ kann das Prozessmodul jedoch auch ohne Hubsystem realisiert werden, wobei der Verschluss der Prozesskammer durch eine andere Mechanik, wie beispielsweise eine geneigte Ebene, realisiert wird.

In einer vorteilhaften Weiterbildung eines solchen erfindungsgemäßen Prozessmoduls weist das Hubsystem wenigstens eine Heizplatte oder eine Strahlungsheizung auf. Die Substrate sollen in der Prozesskammer eine definierte Temperatur besitzen. Das Hubsystem ist in räumlicher Nähe zu den auf der Trägervorrichtung aufliegenden Substraten angeordnet und somit ein geeigneter Ort für eine Substratheizung. Zur Einstellung oder zur Konstanthaltung der Substrattemperatur eignen sich eine in der Nähe der Substrate angeordnete Heizplatte oder eine Strahlungsheizung, die die zur Konstanthaltung der Substrattemperatur erforderliche Wärme an die Substrate liefert. Bevorzugt werden die Substrate bereits vortemperiert mit erhöhter Temperatur transportiert, sodass die Heizplatte oder die Strahlungsheizung nur die von den Substraten abgeleitete und abgestrahlte Wärme nachliefern muss.

Ein guter thermischer Kontakt zwischen der Heizplatte und der Trägervorrichtung ist in einem evakuierten Prozessmodul beispielsweise durch eine Stoßankopplung realisierbar, bei welcher eine Wärmeübertragung mit Hilfe von Gasteilchen erfolgt. Bei der Stoßankopplung wird durch die Anordnung von Heizplatte und Trägervorrichtung oder auch durch ein definiertes Profil oder die Rauigkeit der Oberfläche(n) von Heizplatte und/oder Trägervorrichtung zwischen der Heizplatte und der Trägervorrichtung ein Spalt ausgebildet, wobei der mittlere Abstand zwischen der Heizplatte und der Trägervorrichtung ca. der mittleren freien Weglänge von Gasteilchen in diesem Spalt beträgt. Bei einem solchen Spalt stoßen die Gasteilchen bei ihrer thermischen Bewegung wenig aneinander, sondern vorwiegend an die Trägervorrichtung und die Heizplatte, sodass ein effektiver Wärmeübertrag über das Gas möglich ist. In einem Ausführungsbeispiel kann ein mittlerer Abstand zwischen Heizplatte und Trägervorrichtung bzw. eine Spaltbreite von etwa 50 µm vorgesehen sein, wobei in dem Spalt ein von der Gasart abhängiger Druck von 2 ... 20 mbar optimal sein kann. Als Gas für die Stoßankopplung kann z. B. ein in dem Prozessmodul ohnehin vorhandenes Gas, wie beispielsweise Helium oder Wasserstoff, verwendet werden. Zur Minimierung des Gasverbrauches ist der Spalt durch eine Dichtung begrenzt. Ein solcher guter Wärmeübergang ist vorteilhaft für eine genaue Temperierung der Trägervorrichtung und damit auch der Substrate. Dabei kann die Heizplatte nicht nur als Wärmequelle verwendet werden. Die Heizplatte kann zumindest teilweise auch als Kühlplatte dienen, in welche in die Trägervorrichtung mit Substraten anderweitig eingebrachte Wärme abgeleitet werden kann.

Eine vergleichbare Herangehensweise kann auch innerhalb der Prozesskammer zwischen dem wenigstens einen Substrat und der Trägervorrichtung angewendet werden, um auch dort eine verbesserte thermische Ankopplung erreichen zu können. So kann z. B. die Oberseite der Trägervorrichtung mit einer definierten Rauigkeit ausgebildet sein.

In einer besonders günstigen Ausbildung des erfindungsgemäßen Prozessmoduls ist die Heizplatte oder die Strahlungsheizung heb- und senkbar. Die heb- und senkbare Heizplatte oder Strahlungsheizung kann an die Heb- und Senkbewegung der Trägervorrichtung gekoppelt sein und dadurch eine gleichbleibende Heizung auch bei angehobener Trägervorrichtung ausführen.

In einer weiteren Ausführungsvariante weist das Hubsystem Wärmeisolierblöcke mit einer geringen Wärmeleitfähigkeit auf, wobei auf den Wärmeisolierblöcken eine Auflage der Trägervorrichtung vorgesehen ist. Durch die geringe Wärmeleitfähigkeit der Wärmeisolierblöcke erfolgt wenig Wärmeleitung zwischen Trägervorrichtung und Hubsystem, und das Hubsystem kann auf einer für die mechanische Festigkeit günstigen, niedrigeren Temperatur der Trägervorrichtung gehalten werden. Eine homogene Temperatur der Trägervorrichtung kann trotz fehlender Auflage auf Heizplatten beispielsweise durch den Einsatz einer Strahlungsheizung sichergestellt werden.

In einer bevorzugten Ausgestaltung des erfindungsgemäßen Prozessmoduls weist das Hubsystem einen die Trägervorrichtung seitlich aufnehmenden Hubrahmen auf. Die Substrate liegen regelmäßig zentral auf der Trägervorrichtung auf, und die Randbereiche der Trägervorrichtung werden als Dichtungsbereiche zum Verschluss der Prozesskammer genutzt. An den Randbereichen der Trägervorrichtung bestehen deshalb geringe Anforderungen an die Temperaturkonstanz, sodass an den Randbereichen der Trägervorrichtung die mechanischen Kräfte zum Abdichten der Prozesskammer besonders geeignet übertragen werden können. Mit dem Hubrahmen, der die Trägervorrichtung seitlich aufnimmt, werden die Andruckkräfte direkt auf die Dichtungsflächen übertragen, und die Wärmeableitung über den Hubrahmen wirkt sich kaum auf die Substrattemperatur aus.

In einer vorteilhaften Weiterbildung der Erfindung bildet ein wärmeisolierender Druckkörper mit einer ebenen Auflagefläche eine Auflage des Hubrahmens aus. Über Wärmeisolatoren wird wenig Wärme übertragen, sodass die Temperatur der Trägervorrichtung durch den wärmeisolierten Hubrahmen besonders wenig beeinflusst wird. Durch die Ausbildung des Hubrahmens als Druckkörper mit einer ebenen Auflagefläche wird die Hub- und Schließkraft gleichmäßig und großflächig auf die Trägervorrichtung übertragen, sodass die Trägervorrichtung selbst relativ leicht und kostengünstig ausgebildet werden kann.

Wie oben bereits angedeutet, ist es günstig, wenn die erfindungsgemäße Prozesskammer wenigstens eine Dichtung aufweist, wobei vorgesehen ist, dass die Trägervorrichtung zum Abschluss der Prozesskammer gegen diese Dichtung gedrückt wird. In anderen Ausführungsformen kann die Dichtung auch an der Trägervorrichtung vorgesehen sein. Durch die Dichtung wird eine gute Trennung der inneren Prozesskammer von dem äußeren Prozessmodul erreicht, sodass im Inneren der Prozesskammer ein hohes Maß an Reinheit erreicht wird, wobei die Gase aus der Prozesskammer, die beispielsweise giftig sind, bei geschlossener Prozesskammer nicht in die die Prozesskammer umgebenden Bereiche des Prozessmoduls gelangen. Je nach in der Prozesskammer ausgeführten Prozessen und Aufbau des Prozessmoduls kann jedoch auch ein Verschluss der Prozesskammer ohne Dichtung vorgesehen sein. Eine hohe Reinheit in der Prozesskammer kann dabei beispielsweise durch eine von innen nach außen gerichtete Gasströmung erreicht werden, bei der die Strömungsgeschwindigkeit des Gases größer ist als die Diffusionsgeschwindigkeit von Fremdgasen von außen nach innen.

In einer weiteren vorteilhaften Ausgestaltung weist das erfindungsgemäße Prozessmodul wenigstens eine Stützrolle als Stütze der Trägervorrichtung aus. Durch die erfindungsgemäß möglichen großen mechanischen Abmessungen der Trägervorrichtung kann die Trägervorrichtung anfällig für mechanische Verbiegungen sein. Die auftretenden Kräfte können durch Abstützungen geteilt werden, wobei die Verbiegungen proportional zu den geteilten Kräften verkleinert werden. Die Abstützung ist vorteilhaft als Stützrolle ausgebildet, die reibungs- und verschleißarm betreibbar ist. Die Planarität der Trägervorrichtung kann jedoch nicht nur durch Stützen sichergestellt werden, es gibt auch andere Möglichkeiten. Beispielsweise kann die Trägervorrichtung konvex gewölbt sein und durch den Außendruck, der auf eine evakuierte Prozesskammer wirkt, plangedrückt werden.

Es ist besonders von Vorteil, wenn wenigstens ein die Prozesskammer umgebender oder an die Prozesskammer angrenzender Bereich des Prozessmoduls mit einem Gas füllbar ist. Durch das Füllen des Prozessmoduls mit einem Gas kann in dem Prozessmodul eine gewünschte Atmosphäre geschaffen werden. Dabei kann das Gas entweder ein Inertgas oder ein oxidierend oder ein reduzierend wirkendes Gas sein. Das Gas kann in dem Prozessmodul stationär oder fließend vorgesehen sein. Das Prozessmodul kann dabei als Vakuumkammer vorgesehen sein. Das Prozessmodul kann aber auch eine bei atmosphärischem Druck betriebene Vakuumkammer sein. Das Prozessmodul kann auch eine bei atmosphärischem Druck betriebene Kammer sein, die nicht evakuierbar ist. Eine solche nicht evakuierbare Kammer ist besonders kostengünstig herstellbar.

In einer Weiterbildung weist das erfindungsgemäße Prozessmodul wenigstens eine evakuierbare, die Prozesskammer umschließende Isolierkammer auf, wobei die Isolierkammer wenigstens eine Isolierkammertür aufweist. In dieser Ausbildung der Erfindung sind drei Kammern ineinander geschachtelt. Innen befindet sich die Prozesskammer, die Prozesskammer ist von der Isolierkammer umgeben und die Isolierkammer ist von dem Prozessmodul umgeben. Durch die Dreifachschachtelung ist eine noch bessere thermische und chemische Isolation der Prozesskammer gegenüber der Umgebung als bei einer Zweifachschachtelung möglich. Solche aufwändigen und hoch entwickelten Kammern sind beispielsweise dann sinnvoll, wenn wegen der Verarbeitung hochgiftiger Substanzen erhöhte Sicherheitsanforderungen bestehen oder wenn besonders hohe Anforderungen an die Temperaturgleichförmigkeit vorliegen. Die Isolierkammer kann auch zum Abtrennen einer geöffnet betriebenen Prozesskammer von dem Prozessmodul vorgesehen sein. Ein offener Betrieb der Prozesskammer ist beispielsweise bei Reinigungsprozessen sinnvoll, die auch die Ränder der Trägervorrichtung reinigen sollen.

Gemäß einer anderen Ausgestaltung weist das erfindungsgemäße Prozessmodul wenigstens einen evakuierbaren, an die Prozesskammer angrenzenden Isolierraum auf. Durch den Isolierraum können gezielt bestehende Anforderungen erfüllt werden. Beispielsweise kann durch einen Isolierraum, der an die Decke der Prozesskammer angrenzt, eine gute thermische Isolation der Decke der Prozesskammer und/oder eine homogene horizontale Temperaturverteilung in der Prozesskammer erreicht werden. An den Seitenwänden der Prozesskammer ist in diesem Fall, anders als beim Einsatz einer Isolierkammer, keine thermische Isolation vorhanden. In einem anderen Ausführungsbeispiel ist das Vakuum als elektrischer Isolator für eine in dem Isolierraum befindliche HF-Verteilung vorgesehen. Die Aufgabe des Isolierraumes kann aber auch darin bestehen, eine zusätzliche chemische Abgrenzung zwischen Prozesskammer und Prozessmodul auszubilden. In diesem Fall ist der Isolierraum ein zusätzlicher die Prozesskammer abdichtender Raum, beispielsweise kann ein solcher Isolierraum als differenziell gepumpter Zwischenraum zwischen zwei Dichtungen ausgebildet sein.

In einer bevorzugten Ausbildung des erfindungsgemäßen Prozessmoduls ist die Prozesskammer aus Aluminium oder einer Aluminiumlegierung ausgebildet oder innen mit Aluminium oder eine Aluminiumlegierung verkleidet. Aluminium hat eine Reihe vorteilhafter Eigenschaften. So hat Aluminium beispielsweise eine geringe Dichte, sodass Trägervorrichtungen aus Aluminium ein geringes Gewicht aufweisen. Außerdem besitzt Aluminium eine gute elektrische und thermische Leitfähigkeit. Die Oberfläche von Aluminium bildet eine chemisch stabile und mechanisch dünne Aluminiumoxidschicht aus. In der Praxis erweist sich Aluminium stabil in Reinigungsprozessen, bei denen beispielsweise Ätzgase wie NF₃, SF₆ oder chlorhaltige Ätzgase bzw. auch Fluorkohlenwasserstoffe eingesetzt werden. Außerdem ist ein Kontakt von Aluminium mit einem Halbleiter, wie beispielsweise Silizium, unproblematischer als beispielsweise eine Verunreinigung des Halbleiters mit Kupfer. Bei dem Einsatz von Aluminiumlegierungen werden zusätzlich zu den vorteilhaften Eigenschaften des Aluminiums vorteilhafte Legierungseigenschaften ausgenutzt.

Gemäß einer erweiterten Ausbildung des erfindungsgemäßen Prozessmoduls sind wenigstens zwei Prozesskammern in einer vertikalen Stapelanordnung vorgesehen. Durch die Anordnung von zwei Prozesskammern in einem gemeinsamen Prozessmodul kann der Produktionsdurchsatz nahezu verdoppelt werden. Da sich beide Prozesskammern ein gemeinsames Prozessmodul teilen, erhöhen sich die Anlagenkosten und die Betriebskosten jedoch in geringerem Maße als die Produktivität. So kann z.B. eine gemeinsame Pumpvorrichtung vorhanden sein oder es können auch Vorrichtungen zur Verteilung von Medien auf mehrere Prozesskammern gemeinsam genutzt werden.

In einer Variante weist dieses spezielle erfindungsgemäße Prozessmodul einen Lift zum vertikalen Transportieren der Trägervorrichtung in wenigstens zwei Transportebenen auf. Der Lift kann eine Trägervorrichtung zwischen übereinander liegenden Prozesskammern und Transportebenen bewegen, sodass in dem Prozessmodul ein besonderer Produktionsablauf realisierbar ist. Dabei können zwei oder mehr Prozesskammern mit dem gleichen Prozess betrieben werden, wobei mit Hilfe des Liftes die Logistik zur Benutzung aller Prozesskammern sichergestellt wird. Die Prozesskammern können jedoch auch verschiedene aufeinander aufbauende Prozesse durchführen, wobei der Lift dann zur Realisierung der gewünschten Prozessfolge eingesetzt wird.

In einem bevorzugten Ausführungsbeispiel des erfindungsgemäßen Prozessmoduls ist die Prozesskammer eine Plasmakammer, welche eine als eine erste HF-Elektrode dienende Gasdusche aufweist, wobei die Gasdusche mit der Trägervorrichtung eine Parallelplattenanordnung ausbildet. Parallelplattenreaktoren sind bewährte Maschinen, in denen hochwertige Prozessergebnisse erreicht werden. Derartige Parallelplattenreaktoren werden bevorzugt mit Anregungsfrequenzen zwischen 10 kHz und etwa 100 MHz oder auch gemischten Anregungsfrequenzen betrieben. Abhängig von den konkreten Abmessungen der HF-Elektrode können mehrere Anschlüsse zur Zuführung von HF-Leistung oder auch von Gasanschlüssen vorgesehen werden. Dadurch kann z. B. besonders bei höheren Anregungsfrequenzen eine homogenere Verteilung des elektrischen Stromes auf der Elektrode erreicht werden. Hierbei können die Anregungsfrequenzen sowohl zeitlich gepulst als auch kontinuierlich bereitgestellt werden. Aber auch die Plasmaanregung mit gepulster Gleichspannung kann vorteilhaft sein. Durch den Einsatz des Plasmas ist meistens auch eine Bearbeitung bei relativ geringen Temperaturen und dennoch hoher Bearbeitungsgeschwindigkeit möglich. Die Prozesskammer muss aber nicht zwingend eine Parallelplattenanordnung sein, in der Prozesskammer kann auch beispielsweise eine Reihenanordnung linearer Mikrowellenplasmaquellen zum Einsatz kommen. Die Prozesskammer kann aber auch für einen Prozess ohne Plasma ausgebildet sein. Mögliche plasmafreie Prozesse sind beispielsweise eine katalytische Abscheidung, "Low Pressure CVD (LPCVD)"-Prozesse, "Atomic Layer Deposition (ALD)"- Prozesse und thermische Behandlungen.

Entsprechend einer optionalen Ausbildung des erfindungsgemäßen Prozessmoduls ist die Prozesskammer eine Plasmakammer, welche eine Anordnung mehrerer Plasmaquellen aufweist. Es gibt viele Möglichkeiten der Plasmaerzeugung in einer Plasmakammer mit spezifischen Vor- und Nachteilen. Bei einigen Typen von Plasmakammern ist in der Prozesskammer nur eine Plasmaquelle, beispielsweise als Parallelplattenanordnung, ausgebildet. In anderen Typen von Plasmakammern können auch mehrere Plasmaquellen zur Erzeugung lokal wirkender Plasmabereiche oder eines großflächig wirkenden Plasmas im Einsatz sein. Dies können beispielsweise Mikrowellenplasmen sein, die sich durch hohe Ladungsträgerdichten und Abscheideraten auszeichnen.

Gemäß einer Ausgestaltung weist das erfindungsgemäße Prozessmodul wenigstens eine in oder an der Prozesskammer angeordnete Magnetfeldanordnung auf, wobei die Magnetfeldanordnung entweder feststehend oder bewegbar ausgebildet ist. Durch zusätzliche Magnetanordnungen, deren Magnetfelder definiert durch Wandungen der Prozesskammer und/oder durch die Trägervorrichtung hindurch greifen, kann eine vorteilhafte Beeinflussung auf die Plasmaausbildung und damit z.B. auf die Bearbeitungshomogenität, Bearbeitungsqualität und/oder der Bearbeitungsgeschwindigkeit erreicht werden. Diese Magnetanordnungen können sowohl fixiert angeordnet, als auch definiert, entlang der Begrenzungswände der Prozesskammer und/oder der Trägervorrichtung bewegt werden. In einer weiteren Ausgestaltungsvariante können aber auch definierte Magnetanordnungen innerhalb der Prozesskammer angeordnet werden. Magnetanordnungen können dabei sowohl Permanentmagnetsysteme als auch elektrische Spulensysteme mit oder ohne Polschuhanordnungen sein.

In einer bevorzugten Ausführungsform weist das erfindungsgemäße Prozessmodul wenigstens eine Modulschnittstelle mit einer Modultür zur Einbindung des Prozessmoduls in eine Substratbearbeitungsanlage auf. Eine Substratbearbeitungsanlage in einer Fertigungsumgebung weist neben einem Prozessmodul in der Regel noch weitere Komponenten, wie beispielsweise Schleusenmodule, andere Prozessmodule und Messmodule, auf. Zur Kopplung der Substratbearbeitungsanlage und des Prozessmoduls ist deshalb eine Modulschnittstelle erforderlich. Die Modulschnittstelle soll möglichst eine standardisierte Schnittstelle sein, die einen flexiblen Aufbau von Substratbearbeitungsanlagen aus unterschiedlichen Komponenten erlaubt. Die Modulschnittstelle weist dabei vorzugsweise auch eine Modultür auf, die geöffnet und geschlossen werden kann. Durch eine geschlossene Modultür wird das Prozessmodul und die darin enthaltene Atmosphäre von der übrigen Substratbearbeitungsanlage getrennt, sodass Verunreinigungen in der Substratbearbeitungsanlage von dem Prozessmodul ferngehalten werden. Bei geöffneter Modultür ist ein Transport der Trägervorrichtung zwischen Substratbearbeitungsanlage und Prozessmodul durch die Modultür möglich.

Bevorzugte Ausführungsformen der vorliegenden Erfindung, deren Aufbau, Funktion und Vorteile sollen im Folgenden anhand von Figuren näher erläutert werden, wobei
- Figur 1: schematisch eine Ausführungsform eines erfindungsgemäßen Prozessmoduls in einem vertikalen Querschnitt entlang einer Substrattransportrichtung zeigt;
- Figur 2: schematisch das Prozessmodul aus Figur 1 in einem vertikalen Querschnitt quer zu der Substrattransportrichtung zeigt;
- Figur 3: schematisch eine weitere Ausführungsform des erfindungsgemäßen Prozessmoduls mit zwei vertikal übereinander gestapelten Prozesskammern zeigt;
- Figur 4: schematisch eine nächste Ausführungsvariante des erfindungsgemäßen Prozessmoduls mit einer in eine Isolierkammer eingeschlossenen Prozesskammer zeigt;
- Figur 5: schematisch eine Beladesequenz des Prozessmoduls von Figur 4 zeigt;
- Figur 6: schematisch ein weiteres Ausführungsbeispiel des erfindungsgemäßen Prozessmoduls mit zwei vertikal gestapelten Prozesskammern mit seitlichen Medienanschlüssen zeigt;
- Figur 7: schematisch das Prozessmodul aus Figur 6 mit zwei von Isolierkammern umgebenen Prozesskammern und Hubsystemen in einem vertikalen Querschnitt in Substrattransportrichtung zeigt; und
- Figur 8: schematisch eine weitere Ausbildung des erfindungsgemäßen Prozessmoduls mit Isolierräumen oberhalb und unterhalb der Prozesskammer zeigt.

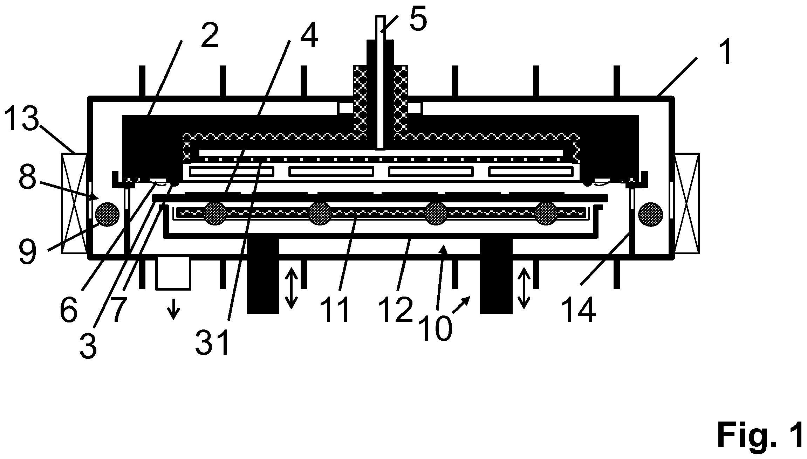

Figur 1 zeigt schematisch eine Ausführungsform eines erfindungsgemäßen Prozessmoduls 1 in einem vertikalen Querschnitt entlang einer Substrattransportrichtung. Innerhalb des Prozessmoduls 1 befindet sich eine Prozesskammer 2. Als Boden der Prozesskammer 2 dient eine Trägervorrichtung 3, auf welcher Substrate 4 aufliegen. Die in Figur 1 exemplarisch dargestellte Prozesskammer 2 ist ein Parallelplattenreaktor zur plasmaunterstützten Abscheidung von Schichten auf den Substraten 4.

Die gasförmigen Ausgangsstoffe für die Schichtabscheidung werden in die Prozesskammer 2 über einen Gasanschlusssatz 5 in eine Gasdusche 31 eingeleitet. Die Gasdusche 31 dient als eine erste HF-Elektrode in dem Parallelplattenreaktor. Die Trägervorrichtung 3 mit den Substraten 4 ist die zweite Elektrode des Parallelplattenreaktors, die parallel zu der Gasdusche 31 ausgerichtet ist.

Damit eine elektrische HF-Leistung von der Gasdusche 31 über die Trägervorrichtung 3 fließen kann, ist eine elektrische Verbindung der Trägervorrichtung 3 mit dem HF-Stromkreis erforderlich. Diese elektrische Verbindung wird in dem in Figur 1 dargestellten Ausführungsbeispiel über einen HF-tauglichen Kontakt 6 hergestellt, der in dem dargestellten Ausführungsbeispiel ein Massekontakt ist. Neben dem HF-tauglichen Kontakten 6 ist eine Dichtung 7 angeordnet, welche bei angehobener Trägervorrichtung 3 die Prozesskammer 2 gegenüber dem Prozessmodul 1 abdichtet.

Die Trägervorrichtung 3 befindet sich in der Darstellung von Figur 1 in einer Transportebene und ist horizontal in der Substrattransportrichtung mittels eines Transportsystems 8 bewegbar. In dem dargestellten Ausführungsbeispiel ist das Transportsystem 8 ein Rollentransportsystem, das Transportrollen 9 aufweist. Das Transportsystem 8 dient hier lediglich zum Transport der Trägervorrichtung 3 in das Transportmodul 1 hinein und aus dem Transportmodul 1 heraus und nicht zum Verschluss der Prozesskammer 2.

Zum Verschluss der Prozesskammer 2 mit der Trägervorrichtung 3 wird ein Hubsystem 10 eingesetzt. Dazu wird die Trägervorrichtung 3 zentral unter der Prozesskammer 2 angeordnet. Anschließend wird die Trägervorrichtung 3 durch das Hubsystem 10 angehoben, wobei die Trägervorrichtung 3 auf einem Hubrahmen 12 aufliegt. Innerhalb des Hubrahmens 12 ist eine Heizplatte 11 angeordnet, welche die Trägervorrichtung 3 und darauf aufliegenden Substrate 4 heizt und somit auf die gewünschte Prozesstemperatur temperiert.

Zur Lagerung der Prozesskammer 2 in dem Prozessmodul 1 dienen Auflagen 14 für die Prozesskammer 12. Das Prozessmodul 1 ist als ein Modul einer Substratbearbeitungsanlage vorgesehen, das über Modulschnittstellen mit der Substratbearbeitungsanlage verbunden ist. An jeder Modulschnittstelle ist eine Modultür 13 vorgesehen, welche schließbar ist, um das Prozessmodul 1 von der Substratbearbeitungsanlage zu trennen. In dem dargestellten Ausführungsbeispiel sind zwei Substrattüren 13 vorhanden, sodass ein Durchlauf der Trägervorrichtung 3 durch eine Modultür 13 in das Prozessmodul 1 hinein und durch die andere Modultür 13 aus dem Prozessmodul 1 heraus möglich ist.

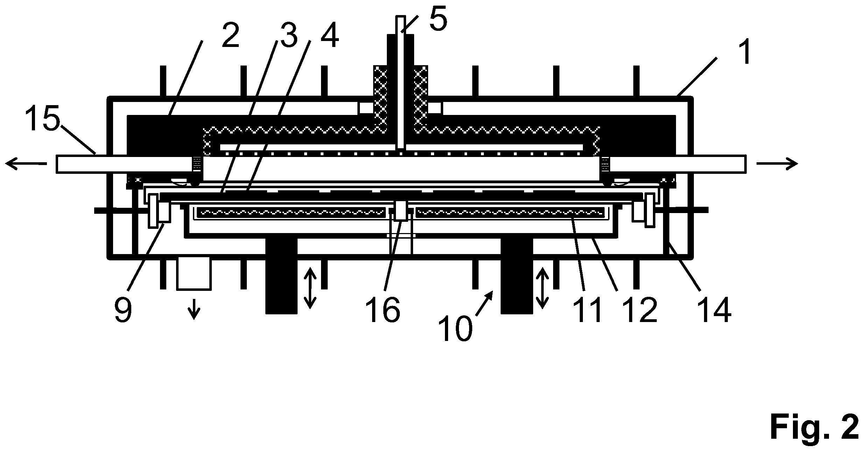

Figur 2 zeigt schematisch das Prozessmodul 1 aus Figur 1 in einem vertikalen Querschnitt quer zu der Substrattransportrichtung. Einige Elemente des Prozessmoduls 1 sind bereits oben anhand von Figur 1 beschrieben worden. In Figur 2 ist zu erkennen, dass die Transportrollen 9 vorliegend Stumpfrollen mit einer seitlichen Führung für die Trägervorrichtung 3 sind. Die Trägervorrichtung 3 ist in Figur 2 in der Transportebene dargestellt, wobei die Trägervorrichtung 3 mittig auf einer Stützrolle(n) 16 oder mehreren nacheinander angeordneten Stützrollen 16, abgestützt ist. Durch die Stützrolle 16 wird ein Durchbiegen der Trägervorrichtung 3 vermieden. Zwischen den Transportrollen 9 und der Stützrolle 16 ist jeweils eine Heizplatte 11 angeordnet. In einer anderen Ausführungsform der Erfindung ist es auch möglich, eine im Bereich der Stützrolle(n) 16 ausgesparte Heizplatte einzusetzen. In der Ansicht von Figur 2 sind auch seitliche Prozesskammerpumpanschlüsse 15 gut zu erkennen, die in Figur 1 nur im Hintergrund als Rechtecke dargestellt sind. Durch die Prozesskammerpumpanschlüsse 15 werden verbrauchte Gase aus der Prozesskammer 2 abgesaugt, wobei die Strömungsrichtung in der gezeigten Ausführungsform durch Strömungsleitbleche optimiert ist.

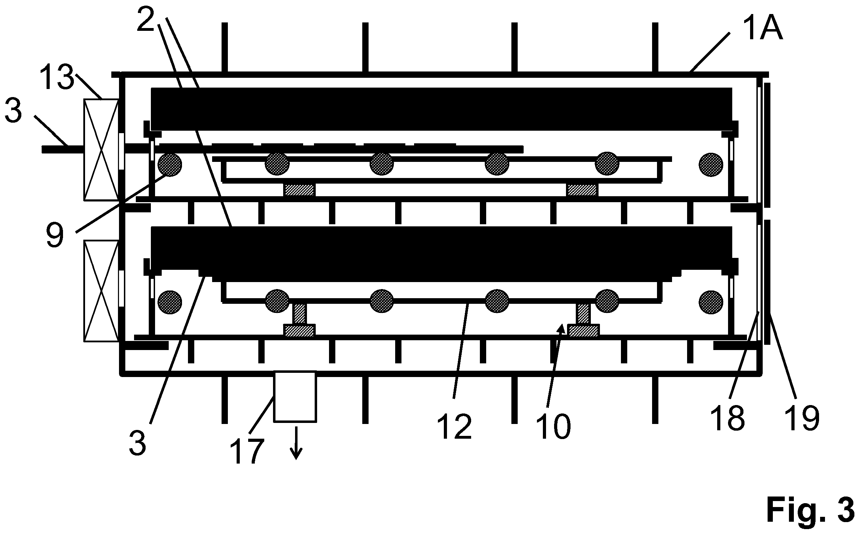

Figur 3 zeigt ein weitergebildetes erfindungsgemäßes Prozessmodul 1A, das zwei Prozesskammern 2 in einer vertikalen Anordnung aufweist. Die Prozesskammern 2 wurden bereits in Bezug auf die Figuren 1 und 2 oben detailliert beschrieben und sind in Figur 3 nur noch stark schematisch dargestellt. Das Prozessmodul 1A ist anders als das Prozessmodul 1 in Figur 1 nicht als Durchlaufmodul sondern als Endmodul ausgebildet. Bei dem Endmodul erfolgt sowohl der Antransport der Trägervorrichtung 3 als auch deren Abtransport nach der Prozessierung durch dieselbe Modultür 13. Bei der oberen Prozesskammer 2 ist die Trägervorrichtung 3 in einer Position während des Transportes dargestellt. Bei der unteren Prozesskammer 2 in Figur 3 ist die Trägervorrichtung 3 durch das Hubsystem 10 in die Prozessierungsebene angehoben und bildet so den Boden der Prozesskammer 2. Das Prozessmodul 1A umgibt beide Prozesskammern 2. Das Gas aus dem Prozessmodul 1A wird über einen Pumpanschluss 17 abgepumpt. Auf der rechten Seite der Darstellung von Figur 3 weist das Prozessmodul 1 zwei Revisionsöffnungen 18 auf, die jeweils von einem Revisionsverschlusselement 19 verschlossen sind. Durch die Revisionsöffnungen 18 sind Wartungsarbeiten in dem Prozessmodul 1A möglich, und die Prozesskammern 2 können durch diese Revisionsöffnungen in das Prozessmodul 1A eingebracht und aus diesem ausgebracht werden.

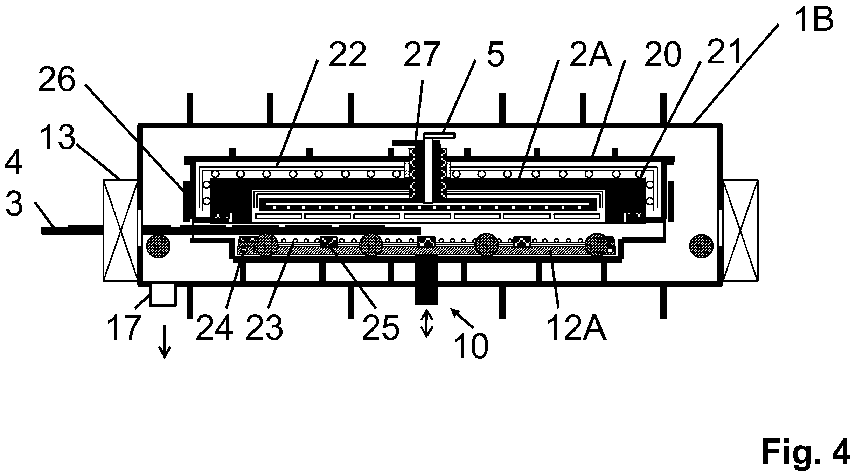

Figur 4 zeigt eine weitere Variante des erfindungsgemäßen Prozessmoduls 1B, bei dem die Prozesskammer 2 in einer Isolierkammer 20 einschließbar ist. Die Isolierkammer 20 ist mit Isolierkammertüren 26 verschließbar, sodass die Prozesskammer 2A doppelt gegenüber der Außenatmosphäre abgegrenzt ist. In dem dargestellten Ausführungsbeispiel sind innerhalb der Isolierkammer 20 Prozesskammer-Temperierelemente 21 und Wärmereflektoren 22 dargestellt. Bei den Prozesskammer-Temperierelementen 21 handelt es sich vorliegend um Heizstäbe, die ihre Temperatur teilweise über Wärmeleitung und teilweise über Strahlung an die Prozesskammer 2A übertragen. In anderen, nicht dargestellten Ausführungsbeispielen können auch andere Prozesskammer-Temperierelemente wie beispielsweise Rohre, durch die eine temperierte Flüssigkeit strömt, zum Einsatz kommen. Unterhalb der Trägervorrichtung 3 ist eine Strahlungsheizung 23 dargestellt, die durch Wärmeisolierblöcke 25 räumlich von der Trägervorrichtung 3 getrennt ist und ihre Wärme durch Wärmestrahlung auf die Trägervorrichtung 3 überträgt. Der Hubrahmen 12A weist Kühlelemente 24 auf, die vorliegend aus von Kühlflüssigkeit durchströmbaren Kanälen bestehen. Durch die Kühlelemente 24 kann eine Überhitzung des Hubrahmens 12A verhindert werden.

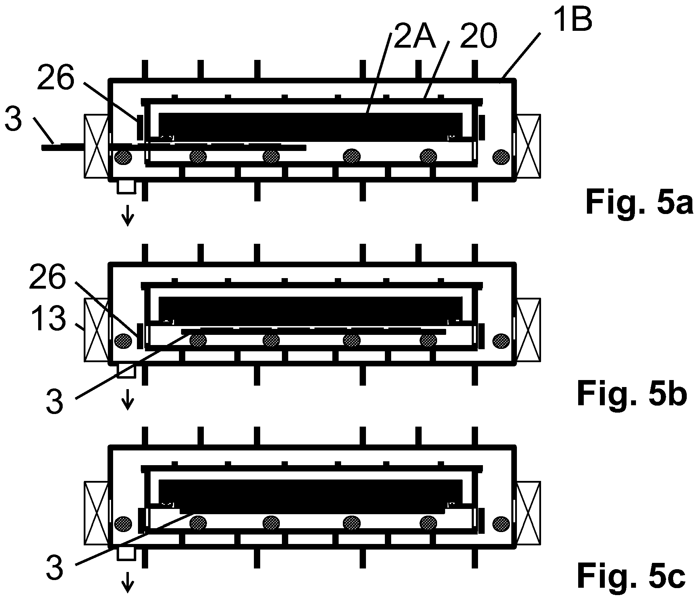

Figur 5 ist eine schematische Darstellung einer Beladesequenz des Prozessmoduls 1B, das bereits in Figur 4 beschrieben wurde. In Figur 5A sind beide Isolierkammertüren 26 geöffnet, und die Trägervorrichtung 3 fährt von links nach rechts in die Isolierkammer 20 ein. In Figur 5B befindet sich die Trägervorrichtung 3 zentral unter der Prozesskammer 2B. Die Isolierkammertüren 26 sind jetzt geschlossen, und in der Isolierkammer 20 kann ein anderer Druck eingestellt werden als in dem Prozessmodul 1B. Die Prozesskammer 2A ist jedoch noch geöffnet und der Druck in der Prozesskammer 2A und in der Isolierkammer 20 ist daher gleich groß. In Figur 5C ist die Prozesskammer 20 geschlossen, und in der Prozesskammer 20 kann ein anderer Druck eingestellt werden als in der Isolierkammer 20, welcher wiederum ein anderer Druck als in dem Prozessmodul 1B sein darf. Die Entladesequenz ist nicht dargestellt, kann aber vom Fachmann aufgrund seiner Fachkenntnisse ohne weitere Anleitung realisiert werden.

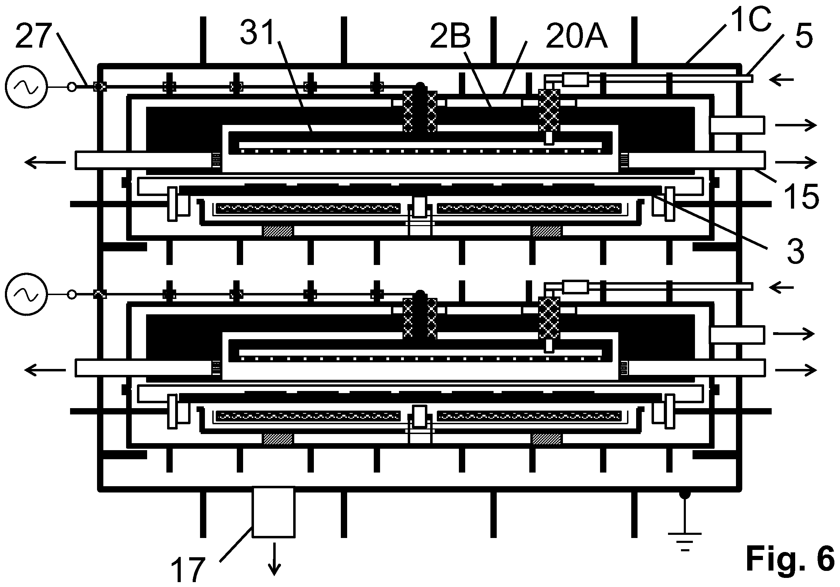

Figur 6 zeigt schematisch ein weiteres erfindungsgemäßes Prozessmodul 1C mit zwei in Isolierkammern 20 befindlichen und vertikal gestapelten Prozesskammern 2B. In der hier dargestellten Ausbildung des Prozessmoduls 1C ist eine HF-Zuleitung 27 aus einer Seitenwand des Prozessmoduls 1C herausgeführt und mittig an einen Duschkopf 31 angeschlossen. Der Gasanschlusssatz 5 ist auch seitlich aus dem Prozessmodul 1C herausgeführt, eine gleichmäßige Gasausströmung aus dem Duschkopf 31 in Richtung der Substrate 4 wird dabei durch die Konstruktion des Duschkopfes 31 sichergestellt.

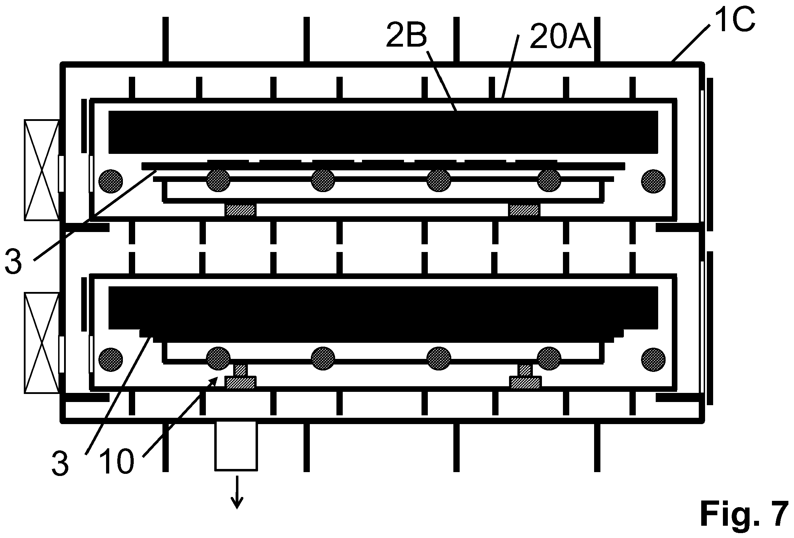

In Figur 7 ist das Prozessmodul 1C von Figur 6 in einem vertikalen Querschnitt entlang der Substrattransportrichtung schematisch dargestellt. Die obere Prozesskammer 2B ist in geöffnetem Zustand dargestellt, wobei das Hubsystem 10 abgesenkt ist. Die untere Prozesskammer 2B ist hingegen geschlossen, wobei das Hubsystem 10 ausgefahren ist und die Trägervorrichtung 3 in der Prozessebene hält.

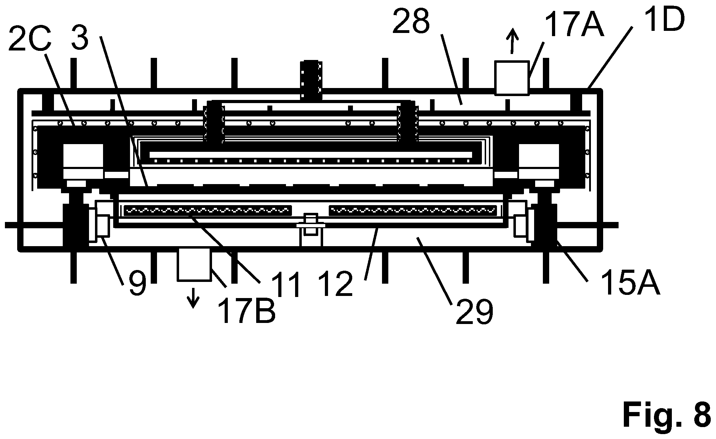

Figur 8 zeigt schematisch ein nächstes erfindungsgemäßes Prozessmodul 1D, das einen oberen Isolierraum 28 und einen unteren Isolierraum 29 aufweist. In dieser Ausbildung ist nicht die gesamte Prozesskammer 2C von einer Isolierkammer umgeben, stattdessen sind lediglich über der Oberseite der Prozesskammer 2C und unter der Trägervorrichtung 3 Isolierräume 28, 29 vorgesehen. Durch die Isolierräume 28 und 29 wird eine gute thermische Isolation der Prozesskammer 2C erreicht. Der obere Isolierraum 28 kann vorteilhaft einen HF-Verteiler zur Verteilung von HF-Energie auf unterschiedliche Speisungspunkte der HF-Elektrode enthalten. Je nach eingestelltem Druck und Wahl des Gases kann damit eine Plasmazündung am HF-Verteiler zuverlässig verhindert werden.

Die Isolierräume 28 und 29 weisen separate Pumpanschlüsse 17A, 17B auf. Dadurch können Sie unabhängig von dem Prozessmodul 1D evakuiert werden.

Neben den dargestellten Ausführungsbeispielen von Prozessmodulen 1, 1A, 1B, 1C, 1D sind auch andere, nicht dargestellte erfindungsgemäße Prozessmodule realisierbar, bei denen die einzelnen dargestellten Elemente anders angeordnet oder kombiniert sein können und/oder bei denen äquivalente Elemente zum Einsatz kommen können.

## Patentansprüche

1. Prozessmodul (1, 1A, 1B, 1C, 1D) mit wenigstens einer in dem Prozessmodul (1, 1A, 1B, 1C, 1D) befindlichen evakuierbaren Prozesskammer (2, 2A, 2B) und wenigstens einer horizontal durch das Prozessmodul (1, 1A, 1B, 1C, 1D) in wenigstens einer Substrattransportrichtung bewegbaren Trägervorrichtung (3) zur Aufnahme von jeweils wenigstens einem flächigen, in der Prozesskammer (2, 2A, 2B) zu prozessierenden Substrat (4),
wobei die wenigstens eine Prozesskammer (2, 2A, 2B) durch die Trägervorrichtung (3), deren Position in wenigstens einer Schließrichtung quer zu der Substrattransportrichtung veränderbar ist, gegenüber dem Prozessmodul (1, 1A, 1B, 1C, 1D) körperlich abschließbar ist, wobei die wenigstens eine Trägervorrichtung (3) einen Boden der wenigstens einen Prozesskammer (2, 2A, 2B) ausbildet,
**dadurch gekennzeichnet, dass** das Prozessmodul als Modul einer Durchlaufanlage ausgebildet ist und die Substrattransportrichtung die Durchlaufrichtung durch die Durchlaufanlage ist oder das Prozessmodul ein Endmodul ist, das eine Öffnung zum An- und Abtransportieren von wenigstens einer Trägervorrichtung aufweist, wobei es zwei Substrattransportrichtungen, eine Einbringrichtung und eine hierzu entgegengesetzte Entnahmerichtung, gibt, und
wobei das Prozessmodul (1, 1A, 1B, 1C, 1D) ein Transportsystem (8) zum Hintransportieren der Trägervorrichtung (3) zu der Prozesskammer (2, 2A, 2B) und/oder zum Wegtransportieren der Trägervorrichtung (3) von der Prozesskammer (2, 2A, 2B) aufweist, wobei das Hin- und/oder Wegtransportieren in einer Transportebene parallel zu einer horizontalen Ausdehnung der Prozesskammer (2, 2A, 2B) vorgesehen ist, wobei die Bewegungsrichtung der Trägervorrichtung (3) bis zu der Prozesskammer (2, 2A, 2B) hin und nach der Bearbeitung von der Prozesskammer (2, 2A, 2B) weg in einer Durchlaufanlage die Durchlaufrichtung ist.

2. Prozessmodul nach Anspruch 1, **dadurch gekennzeichnet, dass** die wenigstens eine Trägervorrichtung (3) elektrisch leitfähig ist oder wenigstens eine elektrisch leitfähige Oberfläche besitzt.

3. Prozessmodul nach wenigstens einem der vorhergehenden Ansprüche, **dadurch gekennzeichnet, dass** die Prozesskammer (2, 2A, 2B) wenigstens einen HF-tauglichen Anschluss oder Kontakt (6) für die Trägervorrichtung (3) aufweist.

4. Prozessmodul nach wenigstens einem der vorhergehenden Ansprüche, **dadurch gekennzeichnet, dass** sich alle Antriebskomponenten des Transportsystems (8) außerhalb der Prozesskammer (2, 2A, 2B) befinden.

5. Prozessmodul nach wenigstens einem der vorhergehenden Ansprüche, **dadurch gekennzeichnet, dass** das Prozessmodul (1, 1A, 1B, 1C, 1D) ein Hubsystem (10) zum Anheben der Trägervorrichtung (3) in eine Prozessierungsebene und zum Absenken der Trägervorrichtung (3) in eine Transportebene aufweist, wobei die Trägervorrichtung (3) in der Prozessierungsebene als Boden der Prozesskammer (2, 2A, 2B) vorgesehen ist.

6. Prozessmodul nach Anspruch 5, **dadurch gekennzeichnet, dass** das Hubsystem (10) wenigstens eine Heizplatte (11) oder eine Strahlungsheizung (23) aufweist.

7. Prozessmodul nach wenigstens einem der Ansprüche 5 oder 6, **dadurch gekennzeichnet, dass** das Hubsystem (10) Wärmeisolierblöcke (25) aufweist, wobei auf den Wärmeisolierblöcken (25) eine Auflage der Trägervorrichtung (3) vorgesehen ist.

8. Prozessmodul nach wenigstens einem der Ansprüche 5 bis 7, **dadurch gekennzeichnet, dass** das Hubsystem (10) einen die Trägervorrichtung (3) seitlich aufnehmenden Hubrahmen (12) aufweist, wobei ein wärmeisolierender Druckkörper mit einer ebenen Auflagefläche als Auflage für den Hubrahmen (12) vorgesehen ist.

9. Prozessmodul nach wenigstens einem der vorhergehenden Ansprüche, **dadurch gekennzeichnet, dass** das Prozessmodul (1, 1A, 1B, 1C, 1D) wenigstens eine Stützrolle (16) zur Stütze der Trägervorrichtung (3) aufweist.

10. Prozessmodul nach wenigstens einem der vorhergehenden Ansprüche, **dadurch gekennzeichnet, dass** das Prozessmodul (1, 1A, 1B, 1C, 1D) wenigstens eine evakuierbare, die Prozesskammer (2, 2A, 2B) umschließende Isolierkammer (20, 20A) aufweist, wobei die Isolierkammer (20, 20A) wenigstens eine Isolierkammertür (26) aufweist.

11. Prozessmodul nach wenigstens einem der vorhergehenden Ansprüche, **dadurch gekennzeichnet, dass** das Prozessmodul (1, 1A, 1B, 1C, 1D) wenigstens einen evakuierbaren, an die Prozesskammer (2, 2A, 2B) angrenzenden Isolierraum (28, 29) aufweist.

12. Prozessmodul nach wenigstens einem der vorhergehenden Ansprüche, **dadurch gekennzeichnet, dass** in dem Prozessmodul (1, 1A, 1B, 1C, 1D) wenigstens zwei Prozesskammern (2, 2A, 2B) in einer vertikalen Stapelanordnung vorgesehen sind und das Prozessmodul (1, 1A, 1B, 1C, 1D) einen Lift zum vertikalen Transportieren der Trägervorrichtung (3) in wenigstens zwei Transportebenen aufweist.

13. Prozessmodul nach wenigstens einem der vorhergehenden Ansprüche, **dadurch gekennzeichnet, dass** die Prozesskammer (2, 2A, 2B) eine Plasmakammer ist, welche eine als eine erste HF-Elektrode dienende Gasdusche aufweist, wobei die Gasdusche mit der Trägervorrichtung (3) eine Parallelplattenanordnung ausbildet.

14. Prozessmodul nach wenigstens einem Ansprüche 1 bis 12, **dadurch gekennzeichnet, dass** die Prozesskammer (2, 2A, 2B) eine Plasmakammer ist, welche eine Anordnung mehrerer Plasmaquellen aufweist.

15. Prozessmodul nach wenigstens einem der vorhergehenden Ansprüche, **dadurch gekennzeichnet, dass** das Prozessmodul (1, 1A, 1B, 1C, 1D) wenigstens eine Modulschnittstelle mit einer Modultür (13) zur Einbindung des Prozessmoduls (1, 1A, 1B, 1C, 1D) in eine Substratbearbeitungsanlage aufweist.

## Claims

1. Process module (1, 1A, 1B, 1C, 1D) with at least one evacuable process chamber (2, 2A, 2B) provided inside the process module (1, 1A, 1B, 1C, 1D) and at least one support device (3) being horizontally moveable through the process module (1, 1A, 1B, 1C, 1D) in at least one substrate transport direction for accommodating at least one flat substrate (4) each, which is to be processed in the process chamber (2, 2A, 2B),
wherein
the at least one process chamber (2, 2A, 2B) is physically closeable against the process module (1, 1A, 1B, 1C, 1D) by the support device (3), whose position changeable in at least one closing direction transversely to the substrate transport direction, wherein the at least one support device (3) forms a bottom of the at least one process chamber (2, 2A, 2B),
**characterized in that**
the process module is formed as a module of an inline device and the substrate transport direction is the inline direction through the inline device or the process module is an end module, which comprises an opening for supplying and removing at least one support device, wherein there are two substrate transport directions, an insertion direction and a removal direction opposite thereto and
wherein the process module (1, 1A, 1B, 1C, 1D) comprises a transport system (8) for supplying the support device (3) to the process chamber (2, 2A, 2B) and/or for removing the support device (3) from the process chamber (2, 2A, 2B), wherein the supplying and/or removing in a transport level is arranged parallelly to a horizontal extension of the process chamber (2, 2A, 2B), wherein the movement direction of the support device (3) towards the process chamber (2, 2A, 2B) and after the processing away from the process chamber (2, 2A, 2B) in the inline device is the inline direction.

2. Process module according to claim 1, **characterized in that** the at least one support device (3) is electrically conductive or at least comprises an electrically conductive surface.

3. Process module according to at least one of the preceding claims, **characterized in that** the process chamber (2, 2A, 2B) comprises at least one HF-compatible connection or contact (6) for the support device (3).

4. Process module according to at least one of the preceding claims, **characterized in that** all drive components of the transport system (8) are located outside the process chamber (2, 2A, 2B).

5. Process module according to at least one of the preceding claims, **characterized in that** the process module (1, 1A, 1B, 1C, 1D) comprises a lifting system (10) for lifting the support device (3) to a processing level and for lowering the support device (3) to a transport level, wherein the support device (3) is forming a bottom of the process chamber (2, 2A, 2B) in the processing level.

6. Process module according to claim 5, **characterized in that** the lifting system (10) comprises at least one heating plate (11) or a radiation heating (23).

7. Process module according to at least one of the claims 5 or 6, **characterized in that** the lifting system (10) comprises thermal insulation blocks (25), wherein a carrier of the support device (3) is provided on the thermal insulation blocks (25).

8. Process module according to at least one of the claims 5 to 7, **characterized in that** the lifting system (10) comprises a lifting frame (12) for laterally receiving the support device (3), wherein a heat insulating pressure component with a flat carrier surface is provided as a carrier for the lifting frame (12).

9. Process module according to at least one of the preceding claims, **characterized in that** the process module (1, 1A, 1B, 1C, 1D) comprises at least one support roller (16) for supporting the support device (3).

10. Process module according to at least one of the preceding claims, **characterized in that** the process module (1, 1A, 1B, 1C, 1D) comprises at least one evacuable insulation chamber (20, 20A) surrounding the process chamber (2, 2A, 2B), wherein the insulation chamber (20, 20A) comprises at least one insulation chamber door (26).

11. Process module according to at least one of the preceding claims, **characterized in that** the process module (1, 1A, 1B, 1C, 1D) comprises at least one evacuable insulation room (28, 29) being located adjacent to the process chamber (2, 2A, 2B).

12. Process module according to at least one of the preceding claims, **characterized in that** at least two process chambers (2, 2A, 2B) are arranged inside the process module (1, 1A, 1B, 1C, 1D) in a vertically stacked arrangement and the process module (1, 1A, 1B, 1C, 1D) comprises a lift for a vertical transport of the support device (3) in at least two transport levels.

13. Process module according to at least one of the preceding claims, **characterized in that** the process chamber (2, 2A, 2B) is a plasma chamber, which has a gas shower serving as a first HF-electrode, wherein the gas shower forms a parallel plate arrangement with the support device (3).

14. Process module according to at least one of the claims 1 to 12, **characterized in that** the process chamber (2, 2A, 2B) is a plasma chamber, which comprises an arrangement of several plasma sources.

15. Process module according to at least one of the preceding claims, **characterized in that** the process module (1, 1A, 1B, 1C, 1D) comprises at least one module interface with a module door (13) for an integration of the process module (1, 1A, 1B, 1C, 1D) into a substrate processing device.

## Revendications

1. Module de traitement (1, 1A, 1B, 1C, 1D) avec au moins une chambre de traitement évacuable (2, 2A, 2B) située dans le module de traitement (1, 1A, 1B, 1C, 1D) et au moins un dispositif porteur (3) étant mouvable horizontalement à travers du module de traitement (1, 1A, 1B, 1C, 1D) dans au moins une direction de transport du substrat et destiné à recevoir respectivement au moins un substrat (4) avec une surface plane qui doit être traité dans la chambre de traitement (2, 2A, 2B),
ladite au moins une chambre de traitement (2, 2A, 2B) étant physiquement verrouillable contre le module de traitement (1, 1A, 1B, 1C, 1D) par le dispositif porteur (3) dont la position est modifiable transversalement par rapport à la direction de transport du substrat dans au moins un sens de fermeture, ledit au moins un dispositif porteur (3) formant un fond de ladite au moins une chambre de traitement (2, 2A, 2B),
**caractérisé en ce que**
ledit module de traitement est formé comme module d'une installation de traitement en continu et que la direction de transport du substrat correspond à la direction de traitement à travers de l'installation de traitement en continu ou bien que le module de traitement est un module de bout qui a une ouverture pour le transport aller et retour d'au moins un dispositif de transport, y existant deux directions de transport, à savoir une direction d'apport et une direction opposée de reprise, et
ledit module de traitement (1, 1A, 1B, 1C, 1D) comprenant un système de transport (8) pour le transport aller du dispositif porteur (3) vers la chambre de traitement (2, 2A, 2B) et / ou le transport retour du dispositif porteur (3) depuis la chambre de traitement (2, 2A, 2B), le transport aller et / ou retour étant prévu à un plan de transport parallèle à une extension horizontale de la chambre de traitement (2, 2A, 2B), la direction de mouvement du dispositif de transport (3) vers la chambre de traitement (2, 2A, 2B) et le mouvement depuis la chambre de traitement (2, 2A, 2B) après le traitement étant la direction de traitement à travers de l'installation de traitement en continu.

2. Module de traitement selon la revendication 1, **caractérisé en ce que** ledit au moins un dispositif porteur (3) est électriquement conducteur ou présente au moins une surface électriquement conductrice.

3. Module de traitement selon au moins l'une des revendications précédentes, **caractérisé en ce que** ladite chambre de traitement (2, 2A, 2B) présente au moins une connexion ou un contact (6) adapté au HF pour le dispositif porteur (3).

4. Module de traitement selon au moins l'une des revendications précédentes, **caractérisé en ce que** tous les composants d'entraînement du système de transport (8) se trouvent à l'extérieur de la chambre de traitement (2, 2A, 2B).

5. Module de traitement selon au moins l'une des revendications précédentes, **caractérisé en ce que** ledit module de traitement (1, 1A, 1B, 1C, 1D) comprend un système de levage (10) pour monter le dispositif porteur (3) vers un plan de traitement et pour abaisser le dispositif porteur (3) vers un plan de transport, le dispositif porteur (3) étant prévu en tant que fond de la chambre de traitement (2, 2A, 2B) au plan de traitement.

6. Module de traitement selon la revendication 5, **caractérisé en ce que** ledit système de levage (10) comprend au moins une plaque chauffante (11) ou un appareil de chauffage par rayonnement (23).

7. Module de traitement selon au moins l'une des revendications 5 ou 6, **caractérisé en ce que** ledit système de levage (10) comprend des blocs isolants thermiques (25), un support du dispositif porteur (3) étant prévu sur les blocs isolants thermiques (25).

8. Module de traitement selon au moins l'une des revendications 5 à 7, **caractérisé en ce que** ledit système de levage (10) présente un cadre de levage (12) qui reçoit le dispositif porteur (3) latéralement, un corps de pression isolant thermique avec une surface de support plane étant prévu comme support pour le cadre de levage (12).

9. Module de traitement selon au moins l'une des revendications précédentes, **caractérisé en ce que** ledit module de traitement (1, 1A, 1B, 1C, 1D) comprend au moins un rouleau de support (16) pour supporter le dispositif porteur (3).

10. Module de traitement selon au moins l'une des revendications précédentes, **caractérisé en ce que** ledit module de traitement (1, 1A, 1B, 1C, 1D) comprend au moins une chambre isolante (20, 20A) évacuable, entourant la chambre de traitement (2, 2A, 2B), la chambre isolante (20, 20A) comprenant au moins une porte de chambre isolante (26).

11. Module de traitement selon au moins l'une des revendications précédentes, **caractérisé en ce que** ledit module de traitement (1, 1A, 1B, 1C, 1D) présente au moins une salle isolante (28, 29) évacuable, adjacente à la chambre de traitement (2, 2A, 2B).

12. Module de traitement selon au moins l'une des revendications précédentes, **caractérisé en ce que** dans ledit module de traitement (1, 1A, 1B, 1C, 1D) au moins deux chambres de traitement (2, 2A, 2B) sont disposées dans un agencement d'empilement vertical et que ledit module de traitement (1, 1A, 1B, 1C, 1D) comprend un élévateur pour transporter verticalement le dispositif porteur (3) vers au moins deux plans de transport.

13. Module de traitement selon au moins l'une des revendications précédentes, **caractérisé en ce que** ladite chambre de traitement (2, 2A, 2B) est une chambre à plasma qui comprend une douche à gaz servant de première électrode HF, la douche à gaz formant un ensemble de plaques parallèles avec le dispositif porteur (3).

14. Module de traitement selon au moins l'une des revendications 1 à 12, **caractérisé en ce que** ladite chambre de traitement (2, 2A, 2B) est une chambre à plasma qui comprend un agencement d'une pluralité de sources de plasma.

15. Module de traitement selon au moins l'une des revendications précédentes, **caractérisé en ce que** ledit module de traitement (1, 1A, 1B, 1C, 1D) comprend au moins une interface de module avec une porte de module (13) pour intégrer le module de traitement (1, 1A, 1B, 1C, 1D) dans une installation de traitement de substrat.
